# EUROPÄISCHE PATENTSCHRIFT

(11) **EP 1 811 819 B1**
(45) Veröffentlichungstag und Bekanntmachung des Hinweises auf die Patenterteilung: **23.03.2011**
(21) Anmeldenummer: 06001109.5
(22) Anmeldetag: 19.01.2006
(51) Int. Cl.: H05K 1/02, G01K 1/14

(54) **Leiterplatte**
Circuit board
Circuit imprimé

(43) Veröffentlichungstag der Anmeldung: 25.07.2007
(73) Patentinhaber: SIEMENS AKTIENGESELLSCHAFT, 80333 München (DE)
(72) Erfinder: Abert, Michael, 76474 Au (DE)

(56) Entgegenhaltungen:
- EP-A- 1 079 674
- DE-C1- 19 814 445
- US-A- 5 712 610
- US-B1- 6 232 868
- US-B1- 6 445 277
- US-B1- 6 734 781
- PATENT ABSTRACTS OF JAPAN Bd. 1997, Nr. 10, 31. Oktober 1997 (1997-10-31) -& JP 09 161635 A (S M C:KK), 20. Juni 1997 (1997-06-20)
- PATENT ABSTRACTS OF JAPAN Bd. 2003, Nr. 12, 5. Dezember 2003 (2003-12-05) -& JP 2005 055422 A (FUJI XEROX CO LTD), 3. März 2005 (2005-03-03)

## Beschreibung

Die Erfindung betrifft eine Leiterplatte mit mehreren im Wesentlichen matrix- oder rasterförmig angeordneten Sensoren. Darüber hinaus betrifft die Erfindung ein elektronisches Gerät mit einer derartigen Leiterplatte.

Ein elektronisches Gerät, insbesondere ein elektronisches Gerät in Form einer speicherprogrammierbaren Steuerung, ist gewöhnlich derart sicherheitstechnisch ausgebildet, dass fehlerhafte Bauteile bzw. Bauelemente das Gerät nicht überhitzen bzw. das Gerät nicht in Brand geraten lassen. Die sicherheitstechnischen Maßnahmen sind auch deshalb zu beachten, um die Erfordernisse bekannter Zulassungsvorschriften, z. B. die Zulassungsvorschriften gemäß CE, UL, FM oder ATEX, zu erfüllen.

Insbesondere im Hinblick auf Leiterplatten, die mit einer Vielzahl von Bauelementen versehen sind, welche zumindest teilweise komplex verschaltet sind, ist im Rahmen einer Geräte-Entwicklung auch eine Vielzahl von möglichen Bauteilefehlern zu berücksichtigen, die nicht zur Überhitzung führen dürfen.
Der Nachweis, dass auch im Fehlerfall die Bauteile bzw. die Bauelemente und deren Verschaltung ein Gerät nicht überhitzen, kann mit einer so genannten Einzelfehler-Analyse erbracht werden. Dazu werden die idealisierten Fehlerbilder "Kurzschluss" und/oder "Unterbrechung" von Bauteilen betrachtet. Allerdings zeigt die Praxis oftmals Fehlerbilder, die von einer derartigen idealisierten Betrachtungsweise abweichen. Beispielsweise kann in der Praxis ein niederohmiges Durchlegieren anstatt eines "idealen" Kurzschlusses vorkommen, wobei dieses niederohmige Durchlegieren ggf. nicht ausreicht, um entsprechende Schutzmaßnahmen auszulösen; allerdings kann durch dieses niederohmige Durchlegieren sehr wohl eine lokale Überhitzung mit Brandgefahr entstehen. Das Fehlerbild "niederohmiges Durchlegieren" ist in der Praxis sehr schwer zu beherrschen und ist sowohl aus technischen Gründen als auch aus Aufwandsgründen oft nicht zu verwirklichen. Daher werden Restrisiken oftmals in Kauf genommen, anstatt geeignete aufwendige Maßnahmen vorzusehen. Z. B. ist es möglich, auf einer Leiterplatte den Querschnitt aller elektrischen Verbindungen zu kurzschlussgefährdeten Kleinsignal-Bauteilen so groß zu dimensionieren, dass über die elektrischen Verbindungen der Mindest-Auslösestrom von Sicherungseinrichtungen, beispielsweise Schmelzsicherungen oder Sicherungsautomaten, ohne Überhitzungsgefahr geführt werden kann. Derartige Maßnahmen sind in komplexen Baugruppen nicht umsetzbar und ggf. nicht ausreichend, denn ein Maximalstrom, welcher vor dem Auslösen einer Sicherungseinrichtung fließt, kann ausreichen, um auf einer Leiterplatte durch fehlerhafte Bauteile bzw. Bauelemente punktuelle Überhitzungen mit Brandgefahr zu bewirken.

Um Überhitzungen zu vermeiden, ist es auch möglich, Temperatursensoren mit einer geeigneten Abschaltvorrichtung an als kritisch erachteten Bauelementen, insbesondere Leistungsbauelementen, anzuordnen. Die Sensoren und die Abschaltvorrichtung können bei erhöhten Sicherheitsanforderungen auch redundant ausgebildet sein. Derartige Maßnahmen sind aufwendig, da eine auf einer Leiterplatte vorhandene Vielzahl von kleinen Bauelementen nicht vollständig temperaturüberwacht werden kann. Darüber hinaus zeigt die Praxis, dass Kleinsignal-Bauelemente, z. B. Kleinsignal-Bauelemente in Form von Widerständen oder Kondensatoren, oftmals Fehlerbilder mit unzulässiger Überhitzung zeigen. Dies ist besonders kritisch, weil diese Bauelemente in großen Mengen eingesetzt werden.

Aus der Druckschrift "Patent Abstract of Japan", Bd. 1997, Nr. 10, Publication Number 09161635 ist eine Trägerplatte mit in Reihe geschalteten Schmelzsicherungen bekannt, wobei Maßnahmen vorgesehen sind, welche die Herstellung einer derartigen Trägerplatte ermöglichen.

US 6,445,277 B1 offenbart eine Sicherheitsvorrichtung für eine elektrische Schaltung. Ein Überstromschutzelement löst eine Schmelzsicherung aus, falls ein zu hoher Strom fließt.

Druckschrift "Patent Abstract of Japan", Bd. 2003, Nr. 12, Publication Number 2005055422 beschreibt eine Anordnung von Sensoren zur Ermittlung von Statussignalen einer Leiterplatte und zur Fehlerdiagnose. Eine Temperaturüberwachung ist nicht vorgesehen.

Der vorliegenden Erfindung liegt die Aufgabe zugrunde, eine Leiterplatte mit einem möglichst zuverlässigen Schutz vor Überhitzung zu schaffen. Darüber hinaus ist ein elektronisches Gerät mit einem verbesserten Schutz vor Überhitzung anzugeben.

Diese Aufgabe wird im Hinblick auf die Leiterplatte mit den im Anspruch 1, im Hinblick auf das elektronische Gerät mit den im Anspruch 6 angegebenen Maßnahmen gelöst.

Vorteilhaft ist, dass durch die "flächige" Temperaturerfassung eine unzulässige Temperaturüberhöhung zuverlässig erkannt wird. Im Hinblick auf Brandrisiken kann ein hoher Sicherheitslevel verwirklicht werden.

Die Sensoren sind im Wesentlichen raster- oder matrixförmig angeordnet, wodurch eine großflächig wirksame Erfassung und Überwachung der zulässigen Temperatur erzielt wird. Dabei werden je nach Sicherheitsanforderung die Rastermaße geeignet festgelegt; das bedeutet, geringe Abstände bzw. Rastermaße, um hohe Sicherheitsanforderungen zu erfüllen, große Abstände bzw. Rastermaße, um geringen Sicherheitsanforderungen zu genügen.

Die Sensoren der Leiterplatte sind matrixverschaltet, dadurch kann eine Auswerteeinheit den Ort der Überhitzung auf der Leiterplatte lokalisieren.

Das Auslösen der Sensoren ist reversibel. Die Leiterplatte braucht in einem elektronischen Gerät nicht zugänglich zu sein, ein Austausch eines Sensors ist nach dessen Auslösen nicht erforderlich.

Der Nachweis, dass auch im Fehlerfall die Bauteile bzw. die Bauelemente und deren Verschaltung ein Gerät nicht überhitzen, wird wesentlich vereinfacht, wodurch Kosten im Rahmen der Entwicklung von elektronischen Geräten vermindert werden. Darüber hinaus sind die Erfordernisse bekannter Zulassungsvorschriften, z. B. die Zulassungsvorschriften gemäß CE, UL, FM oder ATEX, einfacher zu erfüllen, wodurch der Prüfaufwand durch Zulassungsbehörden reduziert, Abnahmen durch diese Behörden erleichtert und Kosten für die Zulassungen von Geräten vermindert werden.
Die Schaltungs-, Leiterplattenlayout- und Bauteileaufwendungen, die im Rahmen der Produktentwicklung individuell zur Sicherstellung des Brandschutzes betrieben werden, reduzieren sich im Wesentlichen auf eine Leiterplatte mit Temperaturerfassung und -überwachung.

In einer Ausgestaltung der Erfindung sind die Sensoren Bestandteil der Leiterplatte, vorzugsweise sind diese in die Leiterplatte integriert, wodurch die Temperaturerfassung und -überwachung nicht für jedes zu entwickelnde elektronische Gerät neu zu verwirklichen ist.

In einer weiteren Ausgestaltung der Erfindung ist eine Auswerteeinheit vorgesehen, welcher die Sensoren ein Meldesignal zuführen, falls die erfasste Temperatur mindestens eines Sensors eine vorgebbare Temperatur erreicht. Das Meldesignal kann von der Auswerteeinheit weiterverarbeitet werden, beispielsweise in der Art und Weise, dass einer übergeordneten oder sonstigen Einheit eine Fehler- und/oder Diagnoseinformation angezeigt und/oder dass die Energiezufuhr für die Leiterplatte und/oder für das diese Leiterplatte aufweisende elektronische Gerät unterbrochen wird.

Die Auswerteeinheit ist vorzugsweise ebenfalls integrierter Bestandteil der Leiterplatte, wodurch die Temperaturerfassung und -überwachung mit einer entsprechenden Auswertung als Basisausstattung der Leiterplatte verwirklicht ist.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1 bis 3: Leiterplatten und
- Figur 4: Mittel zur Temperaturerfassung und/oder -über- wachung.

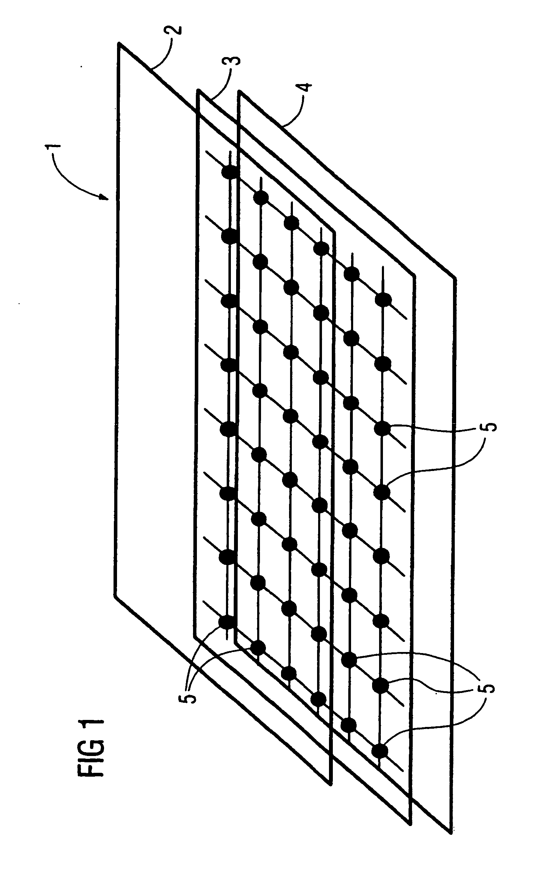

In Figur 1 ist mit 1 eine aus drei Lagen 2, 3, 4 bestehende Leiterplatte bezeichnet, in deren mittleren Lage 3 Sensoren 5 zur Erfassung und/oder Überwachung der Temperatur der Leiterplatte 1 integriert sind. Selbstverständlich können die Sensoren 5 als diskrete Bauteile verwirklicht sein, mit denen die Leiterplatte 1 bestückt ist. Die Sensoren 5 sind im Wesentlichen matrixförmig angeordnet, wodurch auf der gesamten Leiterplatte 1 eine flächig wirksame Erfassung und/oder Überwachung der Temperatur ermöglicht wird.

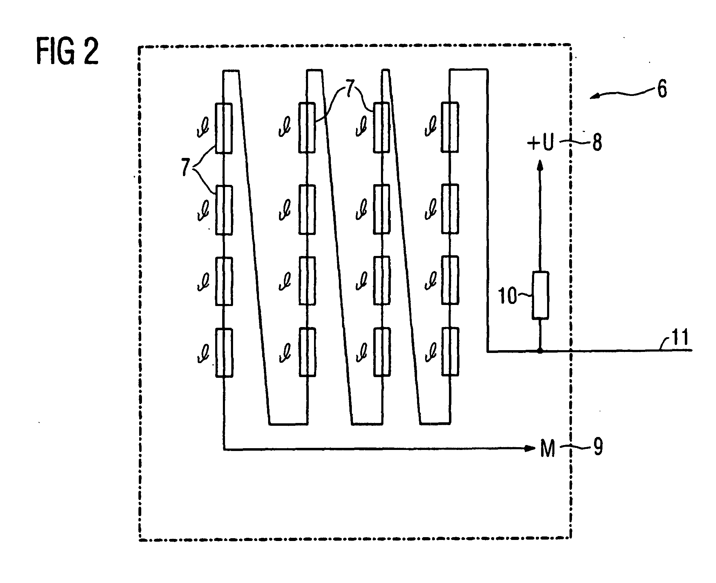

Eine schaltungstechnisch einfache und kostengünstige Temperaturüberwachung wird dadurch verwirklicht, dass die Sensoren einer Leiterplatte 6 in Serie geschaltet sind (Figur 2), wobei die Sensoren als Schmelzsicherungen 7 ausgebildet sind. Für den Fall, dass die Leiterplatte 6 nicht überhitzt ist, fließt aufgrund einer Versorgungsspannung 8 und eines Massepotentials 9 über einen Widerstand 10 und über die Schmelzsicherungen 7 ein Strom, wobei einer hier nicht dargestellten Auswerteeinheit ein Meldesignal in Form eines Spannungssignals von 0 V zugeführt wird. Für den Fall, dass eine der Schmelzsicherungen 7 auslöst, was auf eine Überhitzung der Leiterplatte 6 oder auf eine nicht gewünschte überhöhte Temperatur hinweist, entspricht das Spannungssignal der Versorgungsspannung 8, wodurch der Auswerteeinheit die Überhitzung angezeigt wird. Die Auswerteeinheit, eine dieser übergeordnete Einheit oder eine sonstige Einheit unterbricht daraufhin die Energiezufuhr.

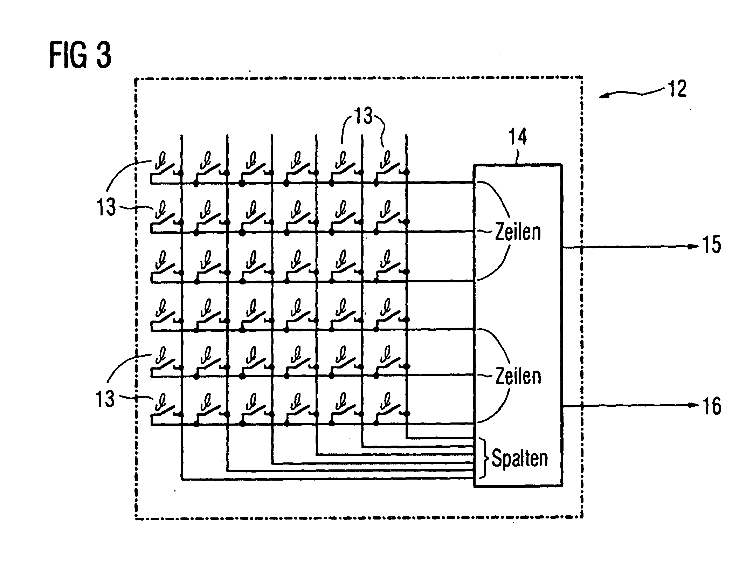

Der Versorgungsstrom der Leiterplatte kann auch direkt über die Schmelzsicherungen geführt werden (nicht gezeigt). In diesem Fall haben die Schmelzsicherungen neben der eigentlichen Aufgabe der Unterbrechung der Stromzufuhr bei Überstrom gleichzeitig eine zweite Aufgabe der Unterbrechung der Stromzufuhr bei Übertemperatur.
Um den Ort der Überhitzung auf der Leiterplatte lokalisieren zu können, sind die Sensoren in Form einer Matrixverschaltung (Kreuzschienenverteilung) miteinander verbunden (Figur 3), d. h., die Sensoren sind zeilen- und spaltenweise in einer Matrix auf der Leiterplatte verschaltet. Eine Leiterplatte 12 weist im vorliegenden Beispiel Sensoren in Form von temperaturabhängigen Mikroschaltern 13 auf, z. B. an sich bekannte PTC-Widerstände mit geeigneter Beschaltung, wobei die elektrischen Zeilen- und Spaltenverbindungen an einer Auswerteeinheit 14 angeschlossen sind. Durch eine derartige Verschaltung ist die Leiterplatte 12 in Planquadrate einteilbar, was bedeutet, dass jedem Planquadrat ein Mikroschalter 13 zugeordnet ist, welcher mit jeweils einer Zeilen- und Spaltenverbindung an die Auswerteeinheit 14 angeschlossen ist. Über die jeweilige Zeilen- und Spaltenverbindung führt die Auswerteeinheit 14 für jeden PTC-Widerstand der Mikroschalter 13 eine Strom- und Spannungsmessung durch und ermittelt den jeweiligen Widerstandswert, welcher ein Maß für die Temperatur eines Planquadrats ist. Über eine Verbindungsleitung 15 zeigt die Auswerteeinheit 14 einer übergeordneten oder sonstigen Einheit an, dass die Temperatur der Leiterplatte 12 oder eines Planquadrats einen zulässigen Wert erreicht oder überschritten hat. Ferner zeigt die Auswerteeinheit 14 dieser Einheit den Ort der Überhitzung über eine weitere Verbindungsleitung 16 an. Um die Sicherheitsanforderungen zu erhöhen, können die Mikroschalter für jedes Planquadrat redundant ausgeführt sein.

Selbstverständlich können die Sensoren anstatt als temperaturabhängige Mikroschalter 13 auch als Schmelzsicherungen ausgebildet sein. Löst eine Schmelzsicherung aus, ist der Stromfluss unterbrochen, d. h. ein Strom, welchen die Auswerteeinheit 14 dieser Schmelzsicherung über die dieser zugehörige Zeilen- oder Spaltenverbindung zuführt, ist unterbrochen und wird der Auswerteeinheit 14 nicht mehr über die dieser Schmelzsicherung zugehörige Spalten- oder Zeilenverbindung zurückgeführt.

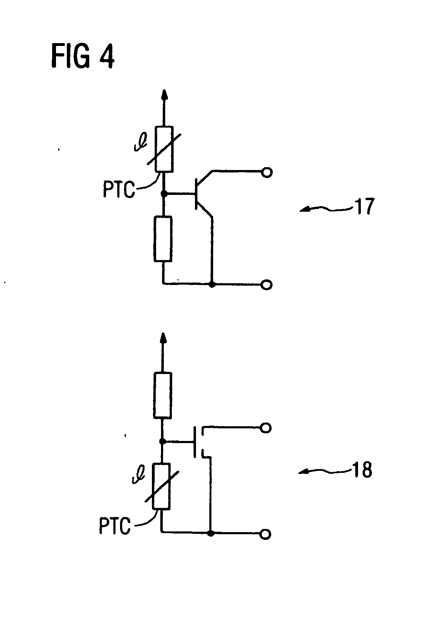

In Figur 4 sind verschiedene Ausführungsformen von Sensoren zur Temperaturerfassung und/oder -überwachung dargestellt. Vorzugsweise kommen Sensoren in Form von PTC-Widerständen mit geeigneter Bipolar- oder Feldeffekt-Transistor-Beschaltung zum Einsatz. Eine Beschaltung 17 ermöglicht den Einsatz des Sensors in einer Serienschaltung, eine weitere Beschaltung 18 den Einsatz des Sensors in einer Matrixverschaltung.

## Patentansprüche

1. Leiterplatte mit mehreren im Wesentlichen matrix- oder rasterförmig angeordneten Sensoren, **dadurch gekennzeichnet, dass** die Sensoren (13, 17, 18) zur Erfassung und Überwachung der Temperatur der Leiterplattenfläche matrixverschaltet sind, wobei die Sensoren bei einer Überhitzung auslösen und wobei das Auslösen reversibel ist.

2. Leiterplatte nach Anspruch 1, **dadurch gekennzeichnet, dass** die Sensoren (13, 17, 18) in oder auf der Leiterplatte (1, 6, 12) integriert sind.

3. Leiterplatte nach Anspruch 1 oder 2, **dadurch gekennzeichnet, dass** die Sensoren (13, 17, 18) einer Auswerteeinheit (14) ein Meldesignal (11) zuführen, falls die erfasste Temperatur mindestens eines Sensors (13, 17, 18) eine vorgebbare Temperatur erreicht.

4. Leiterplatte nach Anspruch 3, **dadurch gekennzeichnet, dass** die Auswerteeinheit (14) in oder auf der Leiterplatte (1, 6, 12) integriert ist.

5. Leiterplatte nach einem der Ansprüche 1 bis 4, **dadurch gekennzeichnet, dass** die Sensoren (13, 17, 18) PTC-Widerstände (PTC) mit geeigneter Beschaltung (18) sind.

6. Elektronisches Gerät mit einer Leiterplatte nach einem der Ansprüche 1 bis 5.

## Claims

1. Printed circuit board having a plurality of sensors arranged essentially in the shape of a matrix or grid, **characterised in that** the sensors (13, 17, 18) are interconnected in a matrix layout for the purpose of detecting and monitoring the temperature of the circuit board surface, the sensors tripping if overheating occurs and the tripping being reversible.

2. Printed circuit board according to claim 1, **characterised in that** the sensors (13, 17, 18) are integrated in or on the printed circuit board (1, 6, 12).

3. Printed circuit board according to claim 1 or claim 2, **characterised in that** the sensors (13, 17, 18) supply an indication signal (11) to an evaluation unit (14) if the temperature detected by at least one sensor (13, 17, 18) reaches a predefinable temperature.

4. Printed circuit board according to claim 3, **characterised in that** the evaluation unit (14) is integrated in or on the printed circuit board (1, 6, 12).

5. Printed circuit board according to one of claims 1 to 4, **characterised in that** the sensors (13, 17, 18) are PTC resistors with an appropriate wiring arrangement (18).

6. Electronic device having a printed circuit board according to one of claims 1 to 5.

## Revendications

1. Plaquette à circuit imprimé comprenant plusieurs capteurs disposés sensiblement en forme de trame, **caractérisée en ce que** les capteurs ( 13, 17, 18 ) sont câblés en matrice pour la détection et le contrôle de la température de la surface de la plaquette à circuit imprimé, les capteurs se déclenchant lors d'une surchauffe et le déclenchement étant réversible.

2. Plaquette à circuit imprimé suivant la revendication 1, **caractérisée en ce que** les capteurs (13, 17, 18) sont intégrés dans ou sur la plaquette (1, 6, 12) à circuit imprimé.

3. Plaquette à circuit imprimé suivant la revendication 1 ou 2, **caractérisée en ce que** le capteur ( 13, 17, 18 ) envoie à une unité ( 14 ) d'exploitation un signal ( 11 ) d'avertissement, si la température relevée d'au moins un capteur ( 13, 17, 18) dépasse une température qui peut être prescrite.

4. Plaquette à circuit imprimé suivant la revendication 3, **caractérisée en ce que** l'unité (14) d'exploitation est intégrée dans ou sur la plaquette **(1,** 6, 12) à circuit imprimé.

5. Plaquette à circuit imprimé suivant l'une des revendications 1 à 4, **caractérisée en ce que** les capteurs ( 13, 17, 18) sont des résistances PTC (PTC) ayant un câblage ( 18 ) approprié.

6. Appareil électronique ayant une plaquette à circuit imprimé suivant l'une des revendications 1 à 5.
